(19) Europäisches Patentamt
European Patent Office
Office européen des brevets

(11) **EP 3 467 844 B1**

(12) **EUROPÄISCHE PATENTSCHRIFT**

(45) Veröffentlichungstag und Bekanntmachung des Hinweises auf die Patenterteilung:
**15.07.2020 Patentblatt 2020/29**

(21) Anmeldenummer: **18191957.2**

(22) Anmeldetag: **31.08.2018**

(51) Int Cl.:
*G21F 1/08* (2006.01)     *G21F 1/12* (2006.01)
*H01L 23/552* (2006.01)    *G21F 3/00* (2006.01)
*B64G 1/54* (2006.01)

(54) **PASSIVER SCHUTZ VOR STRAHLUNG**

PASSIVE PROTECTION AGAINST RADIATION

PROTECTION PASSIVE CONTRE LES RAYONNEMENTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.10.2017 DE 102017123397**

(43) Veröffentlichungstag der Anmeldung:
**10.04.2019 Patentblatt 2019/15**

(73) Patentinhaber: **Airbus Defence and Space GmbH 82024 Taufkirchen (DE)**

(72) Erfinder:
• **SEBALD, Johannes**
  **28199 Bremen (DE)**
• **KESUMA, Hendra**
  **28199 Bremen (DE)**

(74) Vertreter: **Marschall, Stefan Elbpatent Marschall & Partner PartGmbB Jessenstrasse 4 22767 Hamburg (DE)**

(56) Entgegenhaltungen:
| | |
|---|---|
| CN-A- 102 915 780 | CN-A- 103 522 615 |
| JP-A- 2000 263 836 | US-A- 3 465 153 |
| US-A- 3 800 158 | US-A1- 2006 169 489 |
| US-A1- 2007 231 944 | US-A1- 2012 318 928 |
| US-A1- 2015 287 486 | US-B1- 8 575 580 |

**Beschreibung**

Die vorliegende Erfindung betrifft eine Vorrichtung und ein Verfahren zum Schutz vor hochenergetischer bewegter Ladung, insbesondere vor ionisierender, beispielsweise kosmischer Strahlung.

Im Allgemeinen werden zwei Gruppen von Strahlung unterschieden, nämlich ionisierende Strahlung einerseits und nicht-ionisierende Strahlung andererseits.

Während der Energiegehalt der ionisierenden Strahlung ausreicht, Elektronen aus den Schalen neutraler Atome zu entfernen und diese zu ionisieren (Beispiel: schwere Ionen), kann nicht-ionisierende Strahlung keine geladenen Atome (Ionen) erzeugen. Gleichwohl können die Atome durch nicht-ionisierende Strahlung zu Vibrations- und Translations- Bewegungen angeregt werden (Beispiel: Funkwellen, Mikrowellen, sichtbares Licht).

Die ionisierende Strahlung wird in die drei Strahlungstypen Alpha-Strahlung, Beta-Strahlung und Gamma-Strahlung eingeteilt:
Alpha-Strahlung besteht aus zweifach positiv geladenen Heliumkernen, die beim radioaktiven Zerfall schwerer Elemente freigesetzt werden. Beispiele für Alphastrahler sind Radium, Radon, Uran und Thorium. In Luft hat Alpha-Strahlung nur eine Reichweite im Zentimeterbereich, bei ausreichendem Abstand stellt sie somit für den Menschen keine Gefahr dar. Insbesondere ist Alpha-Strahlung normalerweise nicht in der Lage, menschliche Haut oder Kleidung zu durchdringen. Alphaemittierende Materialien können jedoch für den Menschen gefährlich sein, wenn sie durch Einatmen, Verschlucken oder durch offene Wunden aufgenommen werden. In diesem Fall kann nämlich Alpha-Strahlung im Körper lokal freigesetzt werden, was Wechselwirkungen mit dem jeweils umgebenden Gewebe zur Folge haben kann.

Beta-Strahlung ist eine aus Elektronen bestehende Strahlung, die bei Kernzerfallsprozessen (β- Zerfall) entsteht. Beispiele für Betastrahler sind Strontium-90, Kohlenstoff-14, Tritium und Schwefel-35. Beta-Strahlung hat in der Luft eine Reichweite im Meterbereich. Sie kann in die menschliche Haut bis auf die Keimschicht eindringen, in der neue Hautzellen entstehen. Kleidung bietet einen gewissen Schutz gegen Beta-Strahlung .

Gamma-Strahlung besteht aus sehr kurzwelliger, hochenergetischer elektromagnetischer Strahlung, die häufig zusammen mit der Emission von Alpha- und Beta-Strahlung während des radioaktiven Zerfalls von Atomen auftritt. Gamma-Strahlung hat in Luft eine Reichweite von mehreren Metern und kann mehrere Zentimeter in menschliches Gewebe eindringen. Zur Abschirmung von Gamma-Strahlung werden je nach Material erhebliche Schichtdicken benötigt. Kleidung bietet wenig Abschirmung von dieser Strahlung.

Bekannte Vorrichtungen zur Strahlungsabschirmung können mehrere Schichten unterschiedlicher Materialien umfassen. Jedes Material ist dabei zur Abschirmung jeweils einer Strahlungsart besonders geeignet. Zur signifikanten Abschirmung von Alpha- Strahlung kann beispielsweise Papier mit einer Dicke von ca. 10 cm verwendet werden, für die Abschirmung von Beta-Strahlung etwa 3 cm dickes Holz. Selbst eine etwa 30 cm dicke Bleischicht genügt nicht, hochenergetische Gammastrahlung vollständig abzuschirmen.

Auch wenn theoretisch alle Materialien für den Strahlenschutz verwendet werden könnten, ergeben sich somit abhängig von Strahlungsart und Material zum Teil erhebliche erforderliche Schichtdicken. Blei wird allgemein wegen seiner Dichte, seiner hohen Ordnungszahl, hoher Stabilität, einfacher Herstellung-Verfahren, hoher Flexibilität in der Anwendung und seiner Verfügbarkeit eingesetzt.

Obwohl Blei viele Vorteile hat, erfordert seine durch die hohe Dichte ($11,34$ g/cm$^3$) bedingte hohe Masse insbesondere bei Transport und Montage jedoch einen hohen Aufwand, beispielsweise in Bezug auf die aufzubringende Energie. Beispielsweise in der Raumfahrt, wo speziell Einwirkungen von Strahlung des Weltraums auf verschiedene Objekte vermieden werden müssen, ist dies besonders nachteilig, weil die Transportkapazität des Trägers begrenzt ist.

Die vorliegende Erfindung hat die Aufgabe, eine Technik bereitzustellen, die unter geringem Masseaufwand einen effektiven Strahlungsschutz ermöglicht.

Die Aufgabe wird gelöst durch eine Vorrichtung gemäß Anspruch 1 und ein Verfahren gemäß Anspruch 10. Vorteilhafte Ausführungsformen sind in den Unteransprüchen, der Beschreibung und der Figur offenbart.

Eine erfindungsgemäße Vorrichtung dient dem Schutz (eines jeweiligen Objekts) vor hochenergetischer bewegter Ladung, insbesondere vor ionisierender Strahlung. Sie umfasst einen Wafer mit einer Mehrzahl an Mikromagneten.

Ein erfindungsgemäßes Verfahren dient dem Schutz (eines jeweiligen Objekts) vor hochenergetischer bewegter Ladung. Es umfasst ein Überdecken mindestens eines Teils einer Oberfläche eines zu schützenden Objekts mit einer erfindungsgemäßen, gemäß einer der in dieser Schrift offenbarten Ausführungsformen ausgebildeten Vorrichtung. Das Verfahren kann insbesondere im Weltraum angewandt werden. Das zu schützende Objekt kann beispielsweise ein elektronisches Bauteil sein, insbesondere ein elektronisches Bauteil, das ein Element einer Weltraumanwendung ist, beispielsweise in einer Rakete oder in einer Raumstation.

Hochenergetisch geladene Teilchen wie Protonen, Deuteronen oder Alpha-Teilchen werden in magnetischen Feldern durch die Lorentzkraft in ihrer Geschwindigkeit und Richtung beeinflusst. Der Radius r der durch die Lorenzkraft erzwungenen Kreisbewegung der Teilchen ist von deren Ladung q, Geschwindigkeit v und Masse m sowie von der magnetischen Flussdichte B des jeweiligen Magnetfeldes abhängig, genügt nämlich der Gleichung $r = \frac{mv}{qB}$ .

Für eine effiziente Abschirmung gegen die Teilchen ist ein möglichst kleiner Radius r erstrebenswert, was somit durch eine möglichst große Flussdichte B realisiert werden kann.

Die erfindungsgemäße Verwendung von Mikromagneten ermöglicht eine besonders große Anzahl an zugehörigen Ecken und Kanten des magnetischen Materials. An solchen Punkten ist die Dichte des magnetischen Feldes besonders groß. Insbesondere kann so mittels der Mikromagneten die Orientierung und Dichte des erzeugten Magnetfeldes zur lokalen Verstärkung des Magnetfeldes genutzt werden.

Die vorliegende Erfindung bietet somit einen effektiven und dauerhaften passiven Schutzmechanismus gegen hochenergetische bewegte Ladungen, wie insbesondere Protonen, Deuteronen oder Alphateilchen. Durch Anwendung von Mikrosystemtechnik kann dabei die Vorrichtung mit dem Wafer und den Mikromagneten sehr dünn und leicht realisiert sein, was eine einfache Positionierung und einen geringen erforderlichen Energieaufwand beim Transport ermöglicht.

Das zu schützende Objekt kann insbesondere ein elektronisches Bauteil sein. Es kann beispielsweise einen Chip mit elektronischen Schaltungen umfassen. Mit Hilfe der vorliegenden Erfindung können so Wechselwirkungen von Strahlung mit einem derartigen elektronischen Bauteil reduziert oder sogar verhindert werden.

Gemäß einer bevorzugten Ausführungsform ist mindestens einer der Mikromagneten ganz oder teilweise aus $Fe_{16}N_2$ und/oder Neodym gebildet.

Das Seltene-Erden-Metall Neodym bietet die Möglichkeit, sehr hohe magnetische Feldstärken zu erzielen. Das magnetische Material $Fe_{16}N_2$, dessen Kristallstruktur 16 Eisenatome und zwei Stickstoffatome enthält, ist diesbezüglich sogar noch deutlich leistungsfähiger.

Mindestens einer der Mikromagneten kann als gerades oder schiefes Prisma (insbesondere als Quader) oder (gerade oder schiefer) Kreiszylinder ausgebildet sein, der aus einer Oberfläche des Wafers hervorstehend angeordnet sein kann, und/oder mindestens einer der Mikromagneten kann als Stab realisiert sein, dessen längste Erstreckung entlang der Oberfläche des Wafers verläuft. Die letztere Variante ermöglicht eine besonders einfache Herstellung, die erstere eine große Anzahl an Ecken und Kanten und damit ein besonders dichtes Magnetfeld.

Gemäß einer vorteilhaften Ausführungsform der vorliegenden Erfindung ist einer oder sind mehrere der Mikromagneten ganz oder teilweise in eine Oberfläche des Wafers eingelassen, beispielsweise in eine in die Oberfläche eingeätzte und/oder mechanisch eingebrachte Vertiefung.

Insbesondere kann mindestens einer der Mikromagneten ein magnetisches Pulver (z.B. $Fe_{16}N_2$-Pulver und/oder Neodympulver) enthalten, das in eine Vertiefung oder einen Hohlraum des Wafers eingebracht und/oder in ein Trägermaterial eingearbeitet ist (und durch dieses zusammengehalten wird).

Der Wafer mit der Mehrzahl an Mikromagneten kann mindestens teilweise mit einer Beschichtung überzogen sein; dadurch kann eine Ablösung der Mikromagneten vom Wafer verhindert werden.

Vorzugsweise haben die Mikromagneten in mindestens einer Dimension eine Ausdehnung im Bereich von 0,001mm bis 0,2mm. Die Vorrichtung kann somit besonders dünn hergestellt sein.

Insbesondere kann die Vorrichtung als biegsame bzw. verformbare Folie ausgebildet sein; dies erlaubt eine Anpassung der Vorrichtung an ein jeweils abzuschirmendes Objekt.

Gemäß einer vorteilhaften Ausführungsvariante weist die Vorrichtung eine magnetische Feldstärke von mindestens 90, bevorzugter mindestens 100 oder sogar mindestens 120 Megagauß-Oersted (= 15 kJ/m$^3$) auf. Damit kann ein Objekt besonders effektiv gegen Strahlung abgeschirmt werden.

Die Mikromagneten können geometrisch gleich oder unterschiedlich geformt sein. Insbesondere kann die Vorrichtung mindestens zwei Mikromagneten umfassen, die im Querschnitt orthogonal zur Oberfläche des Wafers unterschiedliche geometrische Formen ausbilden. Auf diese Weise kann das Magnetfeld an die jeweiligen Erfordernisse angepasst sein. Beispielsweise kann die Vorrichtung (insbesondere der Wafer) unterschiedliche Bereiche aufweisen, in denen jeweils anders geformte Mikromagneten angeordnet sind.

Gemäß einer bevorzugten Ausführungsform umfasst die Vorrichtung mehrere Wafer, die jeweils eine Mehrzahl an Mikromagneten umfassen und als mehrere Lagen übereinander angeordnet sind, so dass die Oberflächen der Wafer vorzugsweise im Wesentlichen parallel zueinander liegen. Vorzugsweise sind zwei benachbarte Lagen dabei in einem Abstand d>0 zueinander angeordnet. Bevorzugt ist eine Ausführungsform, bei welcher der Abstand d zumindest in einem Bereich der Vorrichtung nicht größer ist als eine Abmessung eines der Mikromagneten des Bereichs in Strahlungsrichtung (die vorzugsweise normal zur Oberfläche mindestens eines der Wafer verläuft) und/oder nicht kleiner als die Hälfte einer derartigen Abmessung.

Derartige Ausführungsformen nutzen eine gegenseitige Beeinflussung der Mikromagneten benachbarter Lagen vorteilhaft aus.

Insbesondere vorteilhaft ist eine Ausführungsform, bei der die Mikromagneten verschiedener Lagen gegeneinander versetzt angeordnet sind. Auf diese Weise können zwischen Mikromagneten eines ersten Wafers hindurchführende mögliche Durchtrittswege für Strahlungsteilchen mittels der Mikromagneten einer anderen Lage mindestens teilweise geschlossen werden. Insbesondere kann - bezogen auf eine vorgesehene Strahlungsrichtung, die vorzugsweise (lokal) orthogonal zu den Oberflächen benachbarter Wafer verläuft - mindestens einer der Mikromagnete mindestens teilweise über einem Zwischenraum zwischen zwei anderen Mikromagneten angeordnet sein.

Gemäß einer vorteilhaften Weiterbildung der vorliegenden Erfindung weist die Vorrichtung mindestens ein Mu-Metall zur Abschirmung eines zu schützenden Objekts gegen ein von den Mikromagneten erzeugtes Magnetfeld auf bzw. umfasst ein erfindungsgemäßes Verfahren ein Anordnen eines Mu-Metalls zwischen dem zu schützenden Objekt und einem Wafer der Vorrichtung. So kann ein schädlicher Einfluss des starken Magnetfelds auf das Objekt verhindert oder zumindest reduziert werden. Das Mu-Metall kann vorzugsweise als Platte oder Folie ausgebildet sein. Ein Abstand f zwischen dem zu schützenden Objekt und dem Mu-Metall ist dabei vorzugsweise höchstens so groß wie eine Abmessung eines der Mikromagnete in vorgesehener Strahlungsrichtung (die vorzugsweise normal zur Oberfläche verläuft) und/oder nicht kleiner als die Hälfte einer derartigen Abmessung.

Gemäß einer Ausführungsform eines erfindungsgemäßen Verfahrens wird das zu schützende Objekt von mehreren Seiten durch eine oder mehrere erfindungsgemäße Vorrichtungen (nach einer in dieser Schrift offenbarten Ausführungsform) Vorrichtung abgeschirmt. Dies ist insbesondere dann vorteilhaft, wenn das Objekt von mehreren Seiten einer Bestrahlung ausgesetzt ist, beispielsweise bei Verwendung des Objekts in einer Weltraumanwendung.

Im Folgenden wird ein bevorzugtes Ausführungsbeispiel der Erfindung anhand einer Zeichnung näher erläutert. Es versteht sich, dass einzelne Elemente und Komponenten auch anders kombiniert werden können als dargestellt.

Es zeigt schematisch:

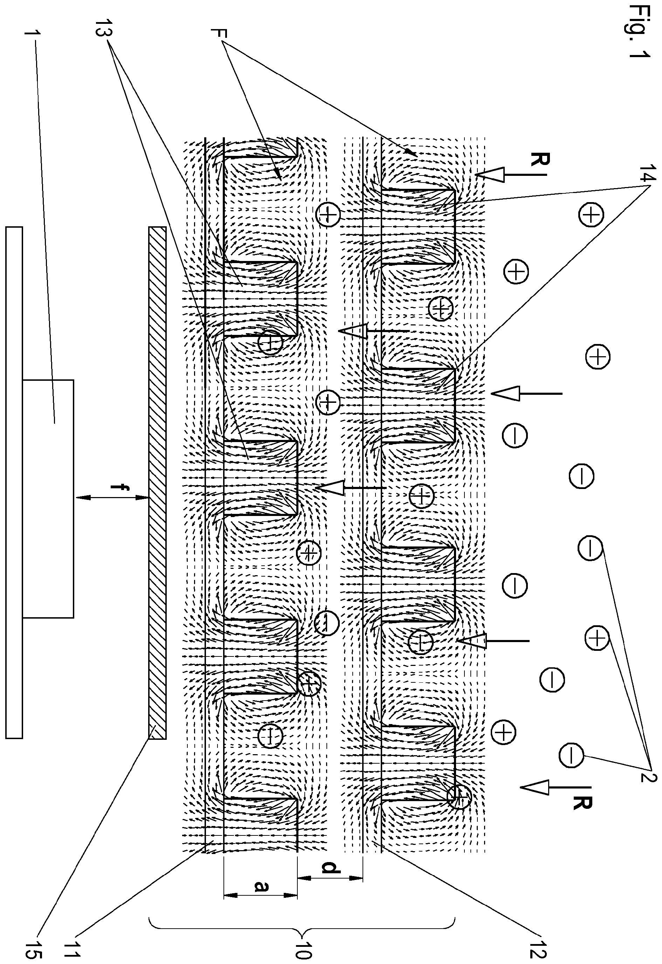

Figur 1: eine Vorrichtung gemäß einer exemplarischen Ausführungsform der vorliegenden Erfindung im Querschnitt.

Eine erfindungsgemäße Vorrichtung 10 dient dem Schutz vor Strahlung, insbesondere vor hochenergetischer bewegter Ladung 2 wie beispielsweise Alpha-Teilchen, Protonen und/oder Deuteronen. Die Vorrichtung umfasst im vorliegenden Beispiel einen (ersten) Wafer 11, an dessen Oberfläche eine Mehrzahl an Mikromagneten 13 angeordnet ist. Das zu schützende Objekt ist im gezeigten Beispiel ein elektronisches Bauteil 1.

Im gezeigten Beispiel sind die Mikromagneten im Querschnitt rechteckig ausgebildet; entlang der Blickrichtung auf die Figur (nicht erkennbar) können sie als langgestreckte Stäbe ausgebildet sein oder einen analogen Querschnitt ausbilden, also als Prismen, insbesondere Quader ausgebildet sein. Diese können dann beispielsweise in zueinander parallelen Reihen entlang der Oberfläche verlaufen, wobei die Prismen (Quader) benachbarter Reihen gegeneinander versetzt sein können.
Die Vorrichtung 10 des dargestellten Ausführungsbeispiels ist mehrlagig ausgebildet: Außer dem Wafer 11, der mit den Mikromagneten 13 eine erste Lage ausbildet, umfasst die Vorrichtung einen Wafer 12, der ebenfalls eine Mehrzahl an Mikromagneten 14 aufweist und - bezogen auf die vorgesehene Strahlungsrichtung R (die orthogonal zu den Oberflächen der Wafer verläuft) - in einem Abstand d über dem Wafer 11 mit dessen Mikromagneten 13 angeordnet ist. Der Wafer 12 bildet mit den Mikromagneten 14 eine zweite Lage der Vorrichtung. Wie aus der Figur ersichtlich, ist d vorliegend kleiner als eine Abmessung a der Mikromagneten 13, 14 in Strahlungsrichtung R.

Die Mikromagneten 14 des Wafers 12 sind vorliegend versetzt zu den Mikromagneten 13 des Wafers 11 angeordnet. Sofern Ladung 2 durch Zwischenräume zwischen den Mikromagneten 12 hindurch treten kann, wird sie daher besonders wirkungsvoll durch die Lage mit dem Wafer 11 und den Mikromagneten 13 abgelenkt, so dass sie das Bauteil 1 nicht schädigen kann.

In der Figur sind die Magnetfelder F der jeweiligen Mikromagneten 13, 14 durch entsprechende Feldlinien veranschaulicht. Diese sind insbesondere an den Kanten der Mikromagneten 13, 14 lokal verstärkt; aufgrund der Mehrzahl an Mikromagneten und damit Vielzahl an Kanten wird in einem großen Bereich der Vorrichtung ein entsprechend starkes Magnetfeld erzeugt, wodurch die auftreffende Ladung wirkungsvoll abgelenkt wird.

Vorzugsweise ist mindestens ein Teil der Mikromagneten 13, 14 mindestens teilweise aus $Fe_{16}N_2$ und/oder Neodym gebildet. Insbesondere können die Mikromagneten aus mit $Fe_{16}N_2$-Pulver und/oder Neodympulver angereicherter (z.B. nachträglich ausgehärteter) Trägermasse bestehen.

Die in der Figur 1 gezeigte Vorrichtung 10 weist weiterhin ein Mu-Metall 15 auf, das vorzugsweise als Blech oder Folie mit einer Stärke von höchstens der Hälfte einer Abmessung a der Mikromagneten 13, 14 in Strahlungsrichtung R ausgebildet ist. Das Mu-Metall 15 ist zwischen den Wafern 11, 12 mit den jeweiligen Mikromagneten 13, 14 und dem Bauteil angeordnet. Es schützt das Bauteil 1, von dem es vorliegend einen Abstand f aufweist. Wie in der Figur erkennbar, ist der Abstand f vorliegend nicht größer als die Abmessungen a der Mikromagnete in vorgesehener Strahlungsrichtung R.

Offenbart ist eine Vorrichtung zum Schutz von Objekten, insbesondere elektronischen Bauteilen einer Weltraumanwendung, vor Strahlung. Die Vorrichtung umfasst einen Wafer 11, 12 mit einer Mehrzahl an Mikromagneten 13, 14. Die Mikromagneten können mindestens teilweise aus $Fe_{16}N_2$ und/oder Neodym bestehen.

Offenbart ist ferner ein Verfahren zum Schutz eines Objekts vor Strahlung. Das Verfahren umfasst ein Überdecken mindestens eines Teils einer Oberfläche des zu schützenden Objekts mit einer Vorrichtung 10, die einen Wafer 11, 12 und eine Mehrzahl an Mikromagneten 13, 14 aufweist.

Bezugszeichen

1    Bauteil
2    Ladung

10    Vorrichtung zum Schutz vor Strahlung
11, 12    Wafer
13, 14    Mikromagnet
15    Mu-Metall

a    Abmessung Mikromagneten in Strahlungsrichtung R
d    Abstand der Lagen der Vorrichtung 1
f    Abstand des Mu-Metalls 15 von einer Lage der Vorrichtung
F    Magnetfeld
R    vorgesehene Strahlungsrichtung

**Patentansprüche**

1.    Vorrichtung (10) zum Schutz vor hochenergetischer bewegter Ladung (2), wobei die Vorrichtung einen Wafer (11, 12) mit einer Mehrzahl an Mikromagneten (13, 14) umfasst.

2.    Vorrichtung gemäß Anspruch 1, wobei die Mehrzahl mindestens einen Mikromagneten (13, 14) umfasst, der mindestens teilweise aus $Fe_{16}N_2$ und/oder Neodym gebildet sind.

3.    Vorrichtung gemäß einem der Ansprüche 1 oder 2, wobei die Mikromagneten als Stäbe ausgebildet sind, die entlang einer Oberfläche des Wafers (11, 12) verlaufen.

4.    Vorrichtung gemäß einem der vorhergehenden Ansprüche, wobei mindestens einer der Mikromagneten ganz oder teilweise in eine Oberfläche des Wafers eingelassen ist.

5.    Vorrichtung gemäß einem der vorhergehenden Ansprüche, wobei mindestens einer der Mikromagneten ein Magnetpulver enthält, das in ein Trägermaterial eingearbeitet ist und/oder in eine Vertiefung oder einen Hohlraum im Wafer eingebracht ist.

6.    Vorrichtung gemäß einem der vorhergehenden Ansprüche, wobei die Mehrzahl mindestens zwei Mikromagneten umfasst, die im Querschnitt orthogonal zur Oberfläche des Wafers voneinander verschiedene geometrische Formen ausbilden.

7.    Vorrichtung gemäß einem der vorhergehenden Ansprüche, wobei die Vorrichtung mehrere Wafer (11, 12) umfasst, die jeweils eine Mehrzahl an Mikromagneten (13, 14) aufweisen und die mehrlagig übereinander angeordnet sind.

8.    Vorrichtung gemäß Anspruch 7, wobei mindestens ein Teil der Mikromagneten (13, 14) verschiedener Lagen gegeneinander versetzt angeordnet sind.

9.    Vorrichtung gemäß einem der vorhergehenden Ansprüche, wobei die Vorrichtung mindestens ein Mu-Metall (15) zur Abschirmung eines zu schützenden Objekts (1) gegen ein von den Mikromagneten (13, 14) erzeugtes Magnetfeld (F) umfasst.

10.    Verfahren zum Schutz vor hochenergetischer bewegter Ladung (2), das ein Überdecken mindestens eines Teils einer Oberfläche eines zu schützenden Objekts mit einer Vorrichtung (10) gemäß einem der vorhergehenden Ansprüche umfasst.

11.    Verfahren gemäß Anspruch 10, wobei die Vorrichtung gemäß Anspruch 9 ausgebildet ist und das mindestens eine Mu-Metall (15) zwischen dem zu schützenden Objekt (1) und einem Wafer (11) angeordnet wird.

12.    Verfahren gemäß einem der Ansprüche 9 oder 10, wobei je mindestens eine Vorrichtung (10) gemäß einem der Ansprüche 1 bis 9 an mehreren Seiten des zu schützenden Objekts angeordnet wird.

13.    Verfahren gemäß einem der Ansprüche 10 bis 13, wobei das zu schützende Objekt ein elektronisches Bauteil (1) ist.

14.    Verfahren gemäß einem der Ansprüche 10 bis 12, wobei das zu schützende Objekt sich im Weltraum befindet.

**Claims**

1.    Device (10) for the protection against moving charges (2) of high energy, the device comprising a wafer (11, 12) having a plurality of micro-magnets (13, 14).

2.    Device according to claim 1, wherein the plurality comprises at least one micro-magnet (13, 14) formed at least partially from $Fe_{16}N_2$ and/or neodymium.

3.    Device according to one of claims 1 or 2, wherein the micro-magnets are formed as bars extending along a surface of the wafer (11, 12).

4.    Device according to one of the foregoing claims, wherein at least one of the micro-magnets is wholly or partially embedded in a surface of the wafer.

5. Device according to one of the preceding claims, wherein at least one of the micro-magnets contains a magnetic powder which is incorporated into a carrier material and/or is inserted into a recess or cavity within the wafer.

6. Device according to one of the foregoing claims, wherein the plurality comprises at least two micro-magnets which, in a cross-section orthogonal to the surface of the wafer, show geometric shapes different from each other.

7. Device according to one of the foregoing claims, wherein the device comprises a plurality of wafers (11, 12) each comprising a plurality of micro-magnets (13, 14), and being arranged in multiple layers one above the other.

8. Device according to claim 7, wherein at least some of the micro-magnets (13, 14) of different layers are arranged offset from one another.

9. Device according to one of the foregoing claims, the device comprising at least one mu-metal (15) for shielding an object (1) to be protected against a magnetic field (F) generated by the micro-magnets (13, 14).

10. Method for the protection against moving charges (2) of high-energy, comprising the step of covering at least a part of the surface of an object to be protected with a device (10) according to one of the preceding claims.

11. Method according to claim 10, wherein the device is arranged according to claim 9 and wherein the at least one mu-metal (15) is placed between the object (1) to be protected and a wafer (11).

12. Method according to one of claims 10 or 11, wherein at least one device (10) according to one of claims 1 to 9 is arranged on each of several sides of the object to be protected.

13. Method according to one of claims 10 to 12, wherein the object to be protected is an electronic component (1).

14. Method according to any one of claims 10 to 12, whereby the object to be protected is located in space.

**Revendications**

1. Dispositif (10) de protection contre une charge en mouvement de haute énergie (2), le dispositif comprenant une tranche (11, 12) ayant une pluralité de micro-aimants (13, 14).

2. Dispositif selon la revendication 1, dans lequel la pluralité comprend au moins un micro-aimant (13, 14) formé au moins partiellement de $Fe_{16}N_2$ et/ou de néodyme.

3. Dispositif selon l'une des revendications 1 ou 2, dans lequel les micro-aimants ont la forme de barres s'étendant le long d'une surface de la tranche (11, 12).

4. Dispositif selon l'une des revendications précédentes, dans lequel au moins un des micro-aimants est entièrement ou partiellement incorporé dans une surface de la tranche.

5. Dispositif selon l'une des revendications précédentes, dans lequel au moins un des micro-aimants contient une poudre magnétique qui est incorporée dans un matériau de support et/ou introduite dans un renfoncement ou une cavité de la tranche.

6. Dispositif selon l'une des revendications précédentes, dans lequel la pluralité comprend au moins deux micro-aimants qui, dans une section transversale orthogonale à la surface de la tranche, ont des formes géométriques différentes les unes des autres.

7. Dispositif selon l'une des revendications précédentes, dans lequel le dispositif comprend une pluralité de tranches (11, 12) comprenant chacune une pluralité de micro-aimants (13, 14) et étant disposées en plusieurs couches les unes au-dessus des autres.

8. Dispositif selon la revendication 7, dans lequel au moins plusieurs des micro-aimants (13, 14) des différentes couches sont disposés de manière décalée les uns par rapport aux autres.

9. Dispositif selon l'une des revendications précédentes, le dispositif comprenant au moins un mumétal (15) pour le blindage d'un objet (1) à protéger contre un champ magnétique (F) généré par les micro-aimants (13, 14).

10. Procédé de protection contre une charge en mouvement (2) de haute énergie, comprenant l'étape consistant à recouvrir au moins une partie de la surface d'un objet à protéger avec un dispositif (10) selon l'une des revendications précédentes.

11. Procédé selon la revendication 10, dans lequel le dispositif est réalisé selon la revendication 9 et le au moins un mumétal (15) est placé entre l'objet (1) à protéger et une tranche (11).

**12.** Procédé selon l'une des revendications 10 ou 11, dans lequel des dispositifs (10) selon l'une des revendications 1 à 9 sont disposés sur plusieurs côtés de l'objet à protéger, avec au moins un desdits dispositifs par coté.

**13.** Procédé selon l'une des revendications 10 à 12, dans lequel l'objet à protéger est un composant électronique (1).

**14.** Procédé selon l'une des revendications 10 à 12, selon lequel l'objet à protéger est situé dans l'espace.

Fig. 1